Europäisches Patentamt

European Patent Office

Office européen des brevets

(19)

(11) Publication number: **0 093 866**
A2

(12) # EUROPEAN PATENT APPLICATION

(21) Application number: 83102888.1

(22) Date of filing: 23.03.83

(51) Int. Cl.³: **H 01 L 29/91**

(30) Priority: 10.05.82 US 376532

(43) Date of publication of application: 16.11.83
Bulletin 83/46

(84) Designated Contracting States: **DE FR GB IT NL**

(71) Applicant: **SIEMENS AKTIENGESELLSCHAFT**, Berlin
und München Wittelsbacherplatz 2,
D-8000 München 2 (DE)

(72) Inventor: **Moyson, Joseph**, 7182 Old Post Road, Boulder
Colorado 80301 (US)

(54) **Schottky diode.**

㊗ A Schottky diode is disclosed which exhibits an increased breakdown voltage without an increased forward voltage drop. The diode has a metal to semiconductor Schottky barrier surrounded by a guard ring (46). The diode is constructed in a mesa configuration so that at least one edge of the guard ring (46) terminates in space.

EP 0 093 866 A2

CROSS-REFERENCE TO
RELATED APPLICATION

The subject matter of this patent application is related to that of my copending U.S. patent application Serial No.          filed
(docket 81 E 8228) entitled "Process For Making Schottky Barrier Devices".

## BACKGROUND OF THE INVENTION

The present invention relates to a Schottky diode; that is, a "one-carrier" device having a metal-to-semiconductor, rectifying barrier. Such a barrier is known as a "Schottky barrier".

It is well known to construct a Schottky diode with a so-called "guard ring" surrounding the metal-to-semiconductor Schottky barrier. Such a guard ring changes the configuration of the depletion layer so as to reduce the high electric field concentration around the edge of the Schottky barrier. While the guard ring thus controls the avalanche or breakdown characteristics of a Schottky diode, resulting in better reverse characteristics, it unfortunately leads to some compromise in the forward characteristics of the device.

The usual way to obtain a guard ring is to diffuse a shallow region of opposite conductivity type through an oxide window at the edge of the Schottky barrier area. Typically, a P-type conductivity region is diffused into an epitaxially grown layer of N-type silicon. This diffusion forms a PN junction which is planar and parallel to the surface at its center and which curves upward toward the surface at its edges.

It is well known that the breakdown of such a PN junction is limited by the minimum radius of curvature of that junction. "Effect of Junction Curvature on Breakdown Voltage in Semiconductors" by S.M. Sze et al., Solid State Electronics, Vol. 9, pp. 831-845, Pergamon Press (1966).

With optimized parameters the guard ring of a Schottky diode breaks down before the Schottky barrier. It would therefore be desirable to increase the radius of curvature of the guard ring PN junction. However, it is not feasible to increase this radius because deeper diffusion of the guard ring region into the N-type epitaxial layer would require a thicker epitaxial layer. Increasing the thickness of this layer increases the forward resistance of the Schottky diode and leads to a higher voltage drop in the forward direction.

In addition to providing a guard ring, it is possible to change the configuration of the depletion layer in a back-biased Schottky diode by changing the size and shape of the area covered by the metallization which, in part, forms the Schottky barrier. If this area is increased, the depletion layer "smooths out" so that high electric field concentrations are avoided. In a preferred form of a Schottky diode, the metallization extends outward from the Schottky barrier at least as far as the outer edge of the guard ring so that the depletion layer beneath the guard ring does not rapidly curve upwards to the semiconductor surface.

## SUMMARY OF THE INVENTION

A principal object of the present invention is to provide a Schottky diode having a guard ring, and a method of making a Schottky diode having a guard ring, in which the breakdown voltage of the device may be increased without correspondingly increasing its forward voltage drop.

This object, as well as other objects which will become apparent from the discussion that follows, are achieved, according to the present invention, by constructing the Schottky diode in a mesa configuration so that the curvature on one side of the guard ring is removed.

The ability to reduce the depth of the guard ring to one micron or less is limited by the requirement that the guard ring have a certain minimum radius of curvature. With a mesa structure having proper surface passivation at the point where the outer edge of the guard ring is exposed, it is possible to construct a Schottky diode with a much shallower guard ring without changing the radius of curvature of this guard ring. By reducing the depth of the guard ring, it is possible to reduce the thickness of the epitaxial layer on the semiconductor substrate. This reduction in epi thickness for a given voltage is important because the forward drop of a Schottky diode is directly dependent upon this thickness. For a 50V Schottky diode, the epi layer thickness is in the order of 4.5 to 5 microns and the guard ring is in the order of 1.5 microns.

With a mesa structure according to the invention, it is possible to reduce the guard ring thickness to about 0.5 microns, thereby reducing the epi thickness to approximately 3.5 microns. In this way, the ohmic drop through the epitaxial layer is correspondingly reduced.

If the guard ring depth is such that the breakdown of the device is determined by the thickness of the epitaxial layer, then the breakdown voltage of the guard ring will be lower than that for the Schottky barrier, thus providing protection for the Schottky barrier.

The foregoing and other objects, features and advantages of the invention will be apparent from the following more particular description of preferred embodiments of the invention, as illustrated in the accompanying drawings.

## BRIEF DESCRIPTION OF THE DRAWINGS

In the drawings:

Fig. 1 is a cross-sectional diagram of a conventional Schottky diode without a guard ring.

Fig. 2 is a cross-sectional diagram of a conventional Schottky diode with a guard ring.

Fig. 3 is a cross-sectional diagram of a conventional Schottky diode in which the Schottky barrier metallization completely covers the surface area above the guard ring.

Fig. 4 is a cross-sectional diagram of a Schottky diode according to the invention having a mesa structure.

Fig. 5 is a cross-sectional diagram showing in detail a portion of the Schottky diode of Fig. 4.

Fig. 6 is a cross-sectional diagram showing in detail a portion of a Schottky diode according to an alternative embodiment of the present invention.

Fig. 7 is a diagram of breakdown voltage, $V_B$, versus substrate impurity concentration, $N_B$, for different values of junction radius, $r_j$, for abrupt PN junctions in silicon.

Figs. 8A-8J are cross-sectional diagrams of a semiconductor device illustrating successive steps for producing a Schottky diode according to the present invention.

Fig. 9 is a plan view of the semiconductor structure shown in Fig. 8C.

Figs. 10A-10H are cross-sectional diagrams of a semiconductor device illustating successive steps in an alternative method for fabricating a Schottky diode according to the present invention.

## DESCRIPTION OF THE PREFERRED EMBODIMENTS

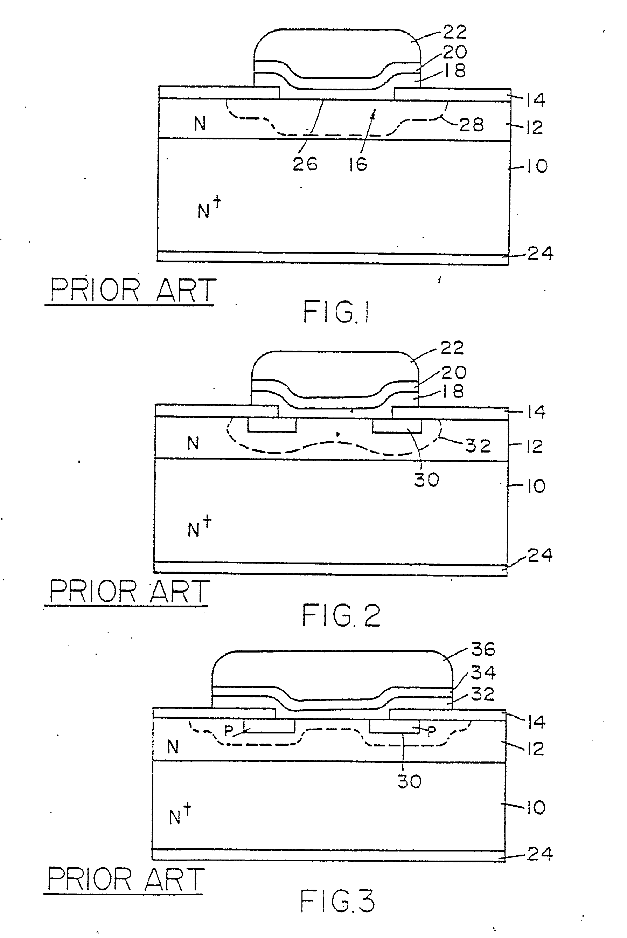

The preferred embodiments of the present invention will now be described with reference to Figs. 1-10 of the drawings. Identical elements of the same semiconductor device shown in the various figures are designated with the same reference numerals.

Fig. 1 shows a typical Schottky diode according to the prior art which has no guard ring for increasing the breakdown voltage. This diode is normally manufactured in quantity on a semiconductor wafer and then cut into individual discrete components for testing and packaging. The device consists of a semiconductor substrate 10 on which is grown an epitaxial layer 12. In this example, the substrate 10 is doped with arsenic (As) to form an $N^+$ background region and the epi layer 12 is doped with phosphorous (P) to form an N region. The thickness of the epi layer is critical since it determines the forward voltage drop of the device. The preferred range of thickness for the epi layer is 2.5 -. 6.0 microns.

Above the epitaxial N-type layer 12 is a thermally grown insulating layer 14 of silicon dioxide ($SiO_2$). A window 16 is opened in this insulating layer to permit contact with the epi layer 12 by a metal layer 18. In forming the device, a succession of metal layers 18 and 20 are vacuum sputtered onto the upper surface of the wafer. This metal is preferably tungsten (W) or molybdenum (Mo) for the layer 18 and platinum (Pt), nickel (Ni), gold (Au), silver (Ag), palladium (Pd) or copper (Cu) for the layer 20. Thereafter, a photo-resist mask is applied to the metallized surface of the substrate and a metal bump 22, e.g. of silver (Ag), is electrochemically plated onto the layer 20. The mask is then removed and the layers 20 and 18 are successively removed from the surface of the insulating layer 14 by back sputtering and chemical removal, respectively. As illustrated in Fig. 1, these layers 20 and 18 remain intact beneath the metal bump 22. Finally, an ohmic contract 24, e.g. of nickel (Ni), is electroplated onto the opposite surface of the semiconductor substrate 10.

When the Schottky diode is forward biased, one component of its resistance is determined primarily by the ohmic drop across the epitaxial layer 12. Consequently, the thinner this layer is, the lower will be the forward voltage drop. When back biased, a space charge or depletion layer is formed adjacent the metal-to-semiconductor Schottky barrier 26. The outer boundary of this depletion layer is indicated by the dashed line 28.

In view of the high electric field concentrations associated with the depletion layer in the Schottky diode of Fig. 1, it is known to add a guard ring 30 to this configuration as shown in Fig. 2. This guard ring changes the shape of the depletion layer in the manner shown in Fig. 2 as illustrated by the dashed line 32. While the use of this guard ring does improve the breakdown characteristics of the Schottky diode, high field concentrations are still present in the area where the outer edges of the depletion layer meet the surface of the epi layer 12.

Fig. 3 illustrates how the shape of the depletion region may be improved by extending the metallization outward to substantially cover the guard ring 30. The layers of metallization, in this case designated 32, 34 and 36 are extended outward over the insulating oxide layer 14 to form a "field plate" which influences the position of the outer edge of the depletion layer indicated by its boundary 38. As shown in Fig. 3, this boundary 38 is moved outward by the field plate thus reducing the high concentration of electric fields and increasing the breakdown voltage of the device.

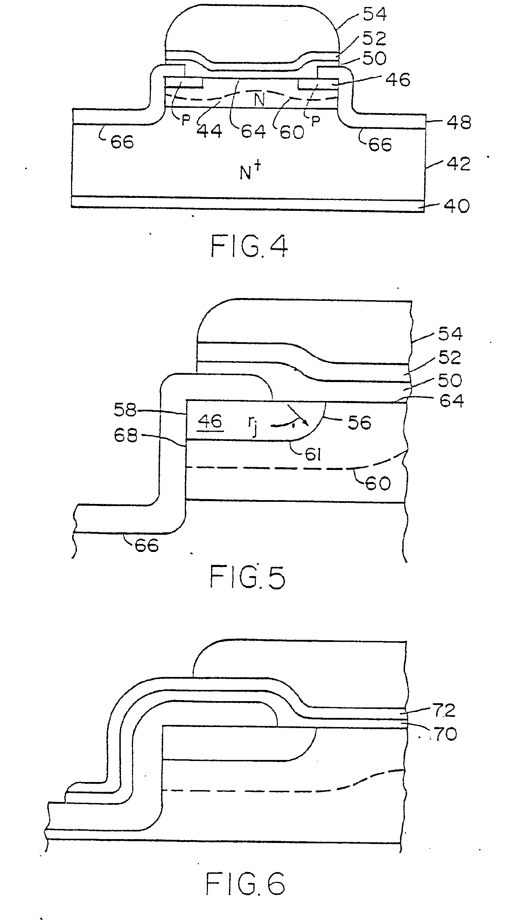

Notwithstanding the field plate effect of the metallization, breakdown in the device of Fig. 3 is initiated along the outer edge of the guard ring at the portion of the PN junction which exhibits the lowest radius of curvature. According to the invention, the breakdown voltage of the device is increased still further by eliminating this outer edge of the guard ring by forming a mesa structure. Figs. 4 and 5 (Fig. 5 showing a portion of the structure of Fig. 4 in expanded detail) illustrate one preferred embodiment of such a mesa structure; Fig. 6 illustrates an alternative preferred embodiment.

Starting from the bottom of the device, the Schottky diode illustrated in Figs. 4 and 5 comprises a nickel plated ohmic contact layer 40, a semiconductor substrate 43 of $N^+$ conductivity, an epitaxial layer 44 of N type conductivity having a thickness in the range of 2.5 - 6.0 microns, a diffused guard ring 46 of P-type conductivity having a thickness of approximately 1 micron, a glass passivation layer 48, a first metal layer 50 of tungsten, a second metal layer 52 of platinum and a metal bump 54 of silver. As shown in detail in Fig. 5, the guard ring 46 has a radius of curvature $r_j$ at its inner edge 56 and extends outward to an exposed outer edge 58. The outer edge therefore does not exhibit a radius of curvature as such; rather, the outer boundary 60 of the depletion layer extends substantially parallel to the lower planar surface 61 of the guard ring.

The semiconductor device shown in Figs. 4 and 5 forms a so-called "mesa" structure whereby the semiconductor substrate 42 and epitaxial layer 44 form a first plateau 64 and a second plateau 66, surrounding the first plateau, with steeply sloping sides 68 extending downward from the first plateau to the second plateau. The layer 48 of glass extends from the first plateau, down the sloping sides and outward onto the second plateau to provide passivation of the exposed surfaces of the substrate 42 and epitaxial layer 44 as well as the guard ring 46.

In the embodiment shown in Figs. 4 and 5, the layers of metallization 50 and 52 terminate abruptly immediately above the steeply sloping sides 68. In the embodiment

-13-

shown in Fig. 6, on the other hand, the layers of metallization 70 and 72 extend from the first plateau downward to the lower, second plateau.

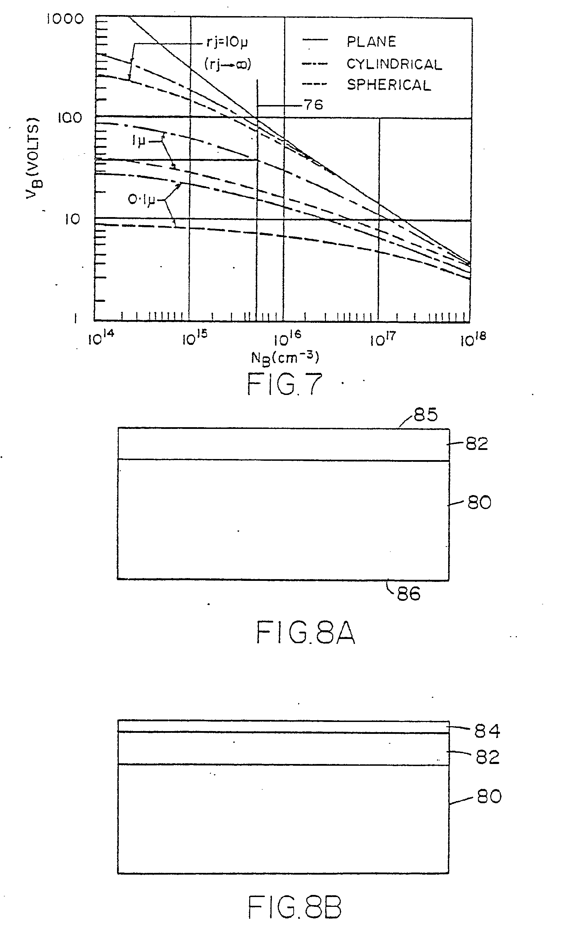

Fig. 7 is a graph showing the dependency of the breakdown voltage, $V_B$, of a PN junction upon the substrate impurity concentration, $N_B$, for different values of the PN junction radius, $r_j$. This figure has been taken from the article "Effect of Junction Curvature on Breakdown Voltage in Semiconductors" by S.M.Sze et al., supra. A planar junction (where $r_j$ is infinite) exhibits the highest breakdown voltage for any given impurity concentration. The smaller the radius of curvature, for either a cylindircal or spherical junction, the lower will be the breakdown voltage. As an example, for $N_B = 6 \times 10^{15}$ cm$^{-3}$, as indicated by the vertical line 76, a 1 micron deep guard ring with cylindrical geometry will have a breakdown voltage of approximately 40V. The planar portion of the guard ring junction will have a breakdown voltage of approximately 85V. The full 85V may not be achieved if the thickness of the guard ring is small enough so that "punch through" becomes a factor.

From the above considerations, it is clear that reducing the depth of the guard ring is very much limited by the curvature effect if the guard ring thickness is less than 1 micron. With the mesa structure shown in Figs. 4-6, the depth of the guard ring may be reduced to the range of 0.5-1 micron, provided that proper surface passivation is achieved. This reduction in depth of the guard ring permits a corresponding reduction in the thickness of the epitaxial layer. Control of the epi layer thickness is important because the forward voltage drop of a Schottky diode is a direct function of this thickness. For a Schottky diode with a guard ring having a thickness in the range of 0.5-1 micron, the epi layer may have a thickness in the range of 3.5 to 4.5 microns.

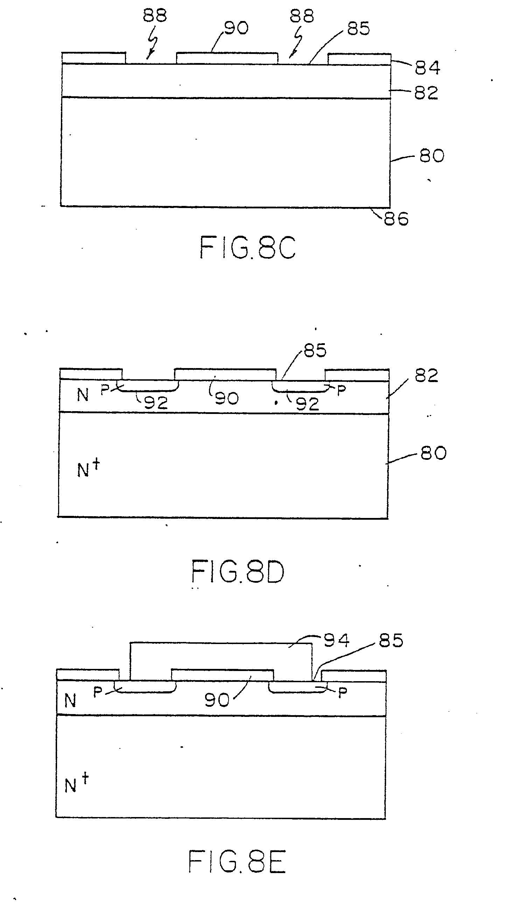

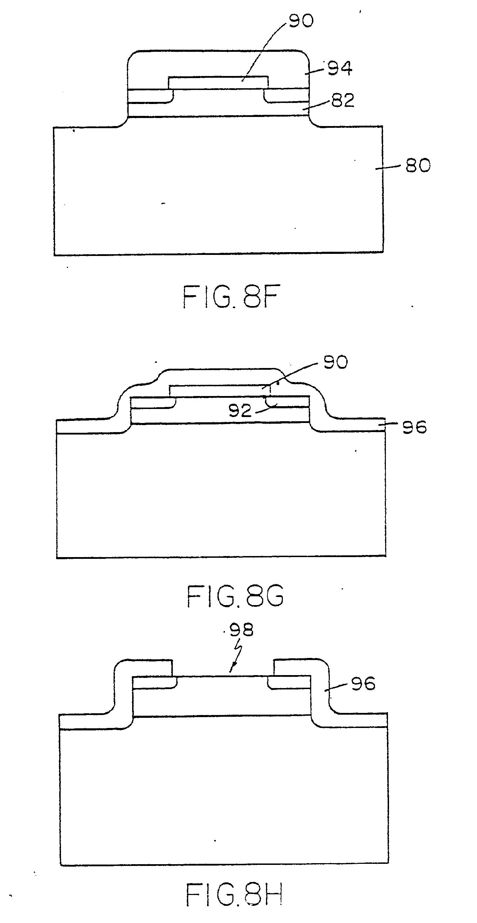

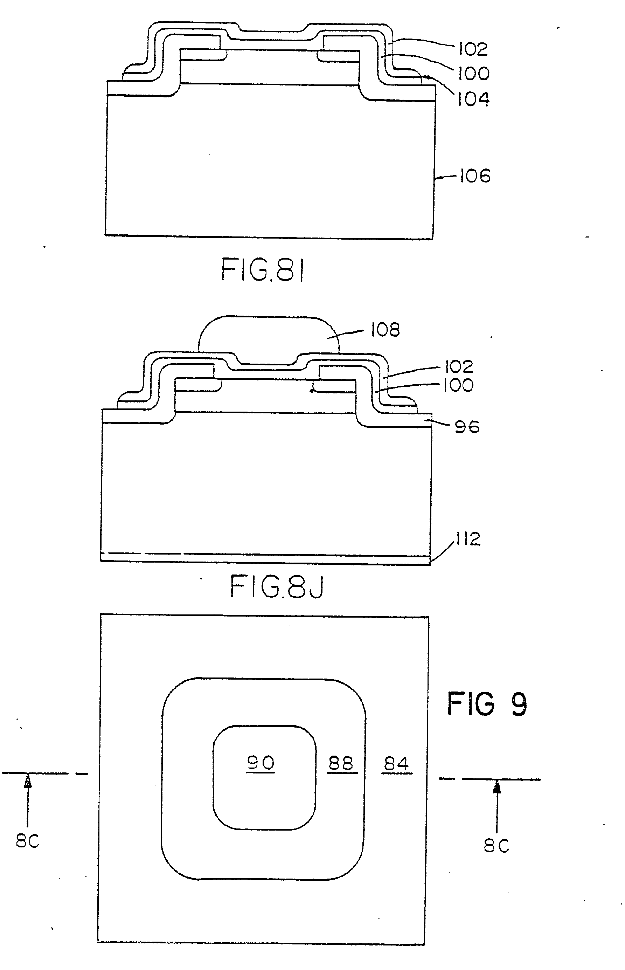

Figs. 8A - 8J illustrate one preferred method for making a Schottky diode with a mesa structure according to the invention. Fig. 8A shows a semiconductor substrate 80 with an epitaxial layer 82. The epi layer 82 provides a first planar surface 85 and the substrate 80 provides a second planar surface 86 opposite the first surface.

The epitaxial layer 82 has a thickness in the range of 2.5 - 6.0 microns for Schottky diodes having breakdown voltages up to 100V. The epi layer should be slightly thicker for higher voltage Schottky diodes.

The $N^+$ - type substrate 80 is formed from an arsenic doped silicon wafer having an impurity concentration that is preferably less than 0.005 $\Omega$cm. The N-type epitaxial layer 82 is grown in a gas phase system in the presence of a phosphorous dopant. The impurity concentration of the epi layer is preferably in the range of 0.4 to 1.5 $\Omega$cm.

As shown in Fig. 8B, a layer 84 of silicon dioxide is next grown on the epitaxial layer 82. A photoresist mask is thereafter applied and areas 88 are etched away, as indicated in Fig. 8C, to expose the first surface 85. The areas 88 define a "window frame" - shaped area on the epi layer 82 which surrounds a central island 90 of the silicon dioxide layer. The window frame-shaped area 88 may be either circular or square with rounded corners as illustrated in Fig. 9. Its inside and outside diameters may be approximately 130 mils and 138 mils, respectively, for a small Schottky diode, or 180 mils and 188 mils, respectively, for a large Schottky diode.

After formation of the frame-shaped window, a guard ring 92 is diffused into the epitaxial layer 82 to a depth of approximately 1 micron. In this example, a P-type conductivity is formed by the diffusion of boron to produce a sheet resistivity in the range of 200 - 350 ohms per square ($\Omega/\square$).

After formation of the guard ring 92 a photoresist mask 94 is applied to the first surface 85 in the configuration shown in Fig. 8E. In particular, this mask covers the central island 90 of the oxide layer 84 and a portion of the window frame-shaped area 88 through which the guard ring diffusion took place. With the mask 94 in position, a mesa is formed on the semiconductor structure by etching away the exposed portion of the silicon dioxide layer 84, the epitaxial layer 82 and the semiconductor substrate 80. The etching may be terminated at any depth desired; in the example shown in Fig. 8F the etching is continued until the substrate 80 is exposed.

The next steps are to remove the mask 94 and to deposit a glass passivating layer 96 over the entire upper surface of the semiconductor structure. In this example, the glass material is Innotech 820 or 830. The glass is deposited by electrophoresis, a process which permits the deposition of a relatively thick layer. The glass layer should be at least 2 microns thick to avoid the possibility of pinholes. In this example, the glass layer 96 is made approximately 10 microns thick to insure pinhole-free passivation.

As shown in Fig. 8H, a window 98 is next opened in the glass layer 96. The window is formed by coating the glass with a photoresist mask, forming a window in this mask and then etching away the glass beneath the window.

As shown in Fig. 8I, the metallization is deposited in two successive layers 100 and 102. In this example, the layers 100 and 102 are tungsten and platinum, respectively.

As illustrated in Fig. 8I, the metallization does not cover the entire upper surface of the semiconductor device. The outer edges 104 of the metallization are recessed slightly from the edges 106 of the device. This recessed edge 104 may be formed in one of two ways: First, the metallization 100, 102 may be deposited over the entire upper surface of the semiconductor device and then etched away around its edges to move the edge 104 back from the edge 106 of the device. Alternatively, it is impossible to deposit the metallization through a physical mask to avoid etching and back sputtering.

Fig. 8J shows the final configuration of the device. A silver bump 108 is deposited onto the metallization 100, 102 through a physical mask.

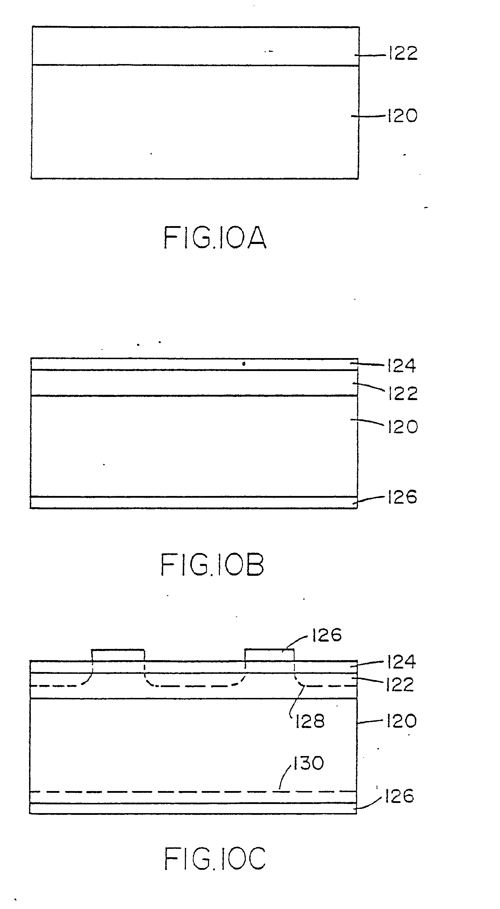

Figs. 10A-10H illustrate a second process for manufacturing a Schottky diode according to the present invention whereby the mesa structure is formed around the window frame-shaped guard ring.

Fig. 10A shows the same starting point structure that is also illustrated in Fig. 8A comprising a semiconductor substrate 120 and an epitaxial layer 122. The wafer, of which the structure shown in Fig. 10A forms a part, is subjected to a Boron diffusion to form regions 124 and 126 on opposite sides of the wafer with a P-type conductivity having a sheet resistivity in the range of 200-350 $\Omega/\square$. Thereafter, as shown in Fig. 10C, a window frame-shaped layer 126 of silicon dioxide is created on the upper surface of the structure. This layer may first be thermally grown and then selectively etched away to leave oxide with the window frame-shaped surface area; i.e., the reverse configuration from that shown in Figs. 8C and 9.

After formation of the oxide layer 126, the semiconductor structure is etched on both sides to the depths indicated by the dashed lines 128 and 130, respectively, in Fig. 10C. Depending upon the thickness of the epitaxial layer 122, this etching may proceed to a depth of 3-4 microns. The resulting structure, after etching, is shown in Fig. 10D.

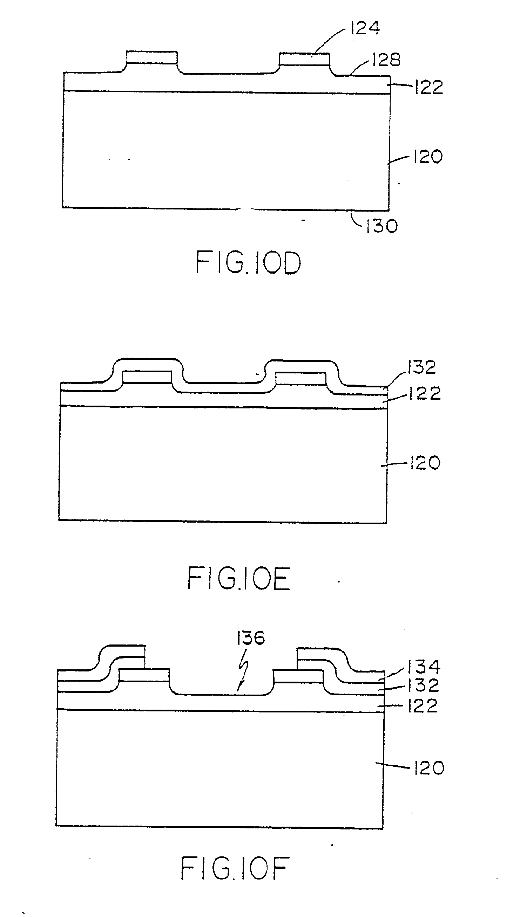

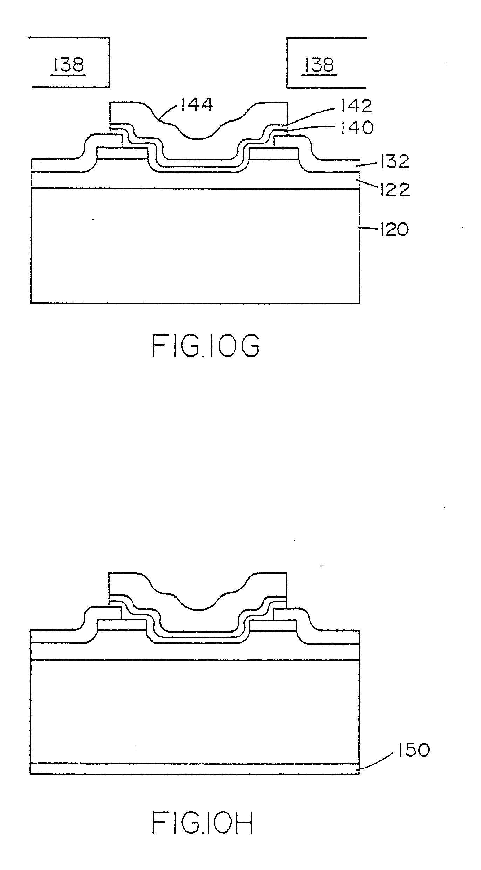

Thereafter, as shown in Fig. 10E, a layer 132 of glass is deposited over the surface of the semiconductor structure. A photoresist mask 134 is provided on the glass layer 132 and the glass is etched away to form a window 136 as shown in Fig. 10F. Three metal layers 140, 142 and 144 of tungsten, platinum and silver, respectively, are then deposited through a physical mask 138 to completely cover the window area 136 as indicated in Fig. 10G.

A layer 150 of nickel is deposited on the back surface of the semiconductor substrate 120 to provide an ohmic contact as indicated in Fig. 10H.

There has thus been shown and described a novel Schottky diode and method of making the same which fulfills all the objects and advantages sought therefor. Many changes, modifications, variations and other uses and applications of the subject invention will, however, become apparent to those skilled in the art after considering this specification and the accompanying drawings which disclose preferred embodiments thereof. All such changes, modifications, variations and other uses and applications which do not depart from the spirit and scope of the invention are deemed to be covered by the invention which is to be limited only by the claims which follow.

Claims

1.   In a Schottky diode comprising:

a)   a semiconductor substrate (43) having
first and second oppositely facing surfaces;

b)   a first background region (44) of one conductivity type disposed in said substrate (43)
adjacent said first surface;

c)   a second region (46) of opposite conductivity type disposed in said substrate (43) within
said first region (44) and adjacent said first
surface, said second region (46) being annular
and defining a window frame-shaped area on said
first surface; thereby forming a guard ring;

d)   a first layer (48) of a first electrically
insulating material disposed on said first surface, said first layer (48) possibly covering a
portion of said window frame area, but not covering the window area of said first surface
within said window frame-shaped area;

e)   a second layer (50) of a first electrically conductive material disposed on said first
surface covering said window area and forming a
rectifying Schottky barrier with said first region (44) in said window area;

f)   means (54) for electrically contacting
said second layer; and

Kot 1 Dx / 03.03.1983

0093866

g)    means (40) for electrically contacting said first region;

characterized in that said first surface has a mesa-shaped cross-section forming an elevated first plateau (64) and steeply sloping sides from said first plateau (64), the outer circumferential edge of said window frame-shaped area defined by said second region (46) being bounded by said steeply sloping sides.

2.    The Schottky diode defined in claim 1, further comprising a third layer (52) of a second electrically conductive material disposed on and substantially continuous with said second layer.

3.    The Schottky diode defined in claim 2, wherein said first electrically conductive material is a first metal.

4.    The Schottky diode defined in claim 3, wherein said second electrically conductive material is a second metal.

5.    The Schottky diode defined in claim 1, wherein said first layer (48) covers at least a part of said window frame-shaped area, the part covered being the outer circumferential portion of said window frame-shaped area, whereby at least the outer portion of said guard ring is covered by said first layer (48).

6.    The Schottky diode defined in claim 1, wherein said second layer (50) covers substantially all of said window frame-shaped area, thereby covering said guard ring.

0093866

7.     The Schottky diode defined in claim 1, wherein said first layer (48) covers said sloping sides at least in the area adjacent said first plateau (64), thereby covering also the edges of said guard ring bounded by said sloping sides.

8.     The Schottky diode defined in claim 1, wherein said first surface extends outward from said steeply sloping sides into a second plateau (66), lower than and surrounding said first plateau (64).

9.     The Schottky diode defined in claim 8, wherein said first layer (48) covers said sloping sides and at least a portion of said second plateau (66) that is contiguous thereto.

10.     The Schottky diode defined in claim 9, wherein said second layer (50) extends outward to and terminates at the edge of said first plateau (64).

11.     The Schottky diode defined in claim 1, wherein said means for electrically contacting said second layer (50) includes a metal bump (54) disposed over said window area and in electrical contact with said second layer (50).

12.     The Schottky diode defined in claim 3, wherein said means (40) for electrically contacting said first region (44) includes a layer of third metal disposed on said second surface.

13.     The Schottky diode defined in any one of claims 1-12, wherein said diode forms a single, discrete, electrical component.

14.     The Schottky diode defined in claim 1, wherein said semiconductor substrate (43) comprises silicon.

15.    The Schottky diode defined in claim 1, wherein said window frame-shaped area is substantially square in outer circumference and has rounded corners.

16.    The Schottky diode defined in claim 1, wherein said first region (44) has an N-type conductivity and said second region (46) has a P-type conductivity.

17.    The Schottky diode defined in claim 1, wherein said first electrically insulating material is silicon dioxide ($SiO_2$).

18.    The Schottky diode defined in claim 1, wherein said first electrically insulating material is a glass.

19.    The Schottky diode defined in claim 12, wherein said first and said third metal are the same.

20.    The Schottky diode defined in claim 1, wherein said first surface of said semiconductor substrate (43) is a substantially planar, mesa-shaped surface.

21.    The Schottky diode defined in claim 1, wherein said second surface of said semiconductor substrate (42) is a substantially planar surface.

22.    The Schottky diode defined in claim 3, wherein said first metal is tungsten.

23.    The Schottky diode defined in claim 4, wherein said second metal is gold.

24.    The Schottky diode defined in claim 11, wherein said metal bump (54) is selectively deposited over said second layer (50) to form a raised ohmic contact.

25.    The Schottky diode defined in either one of claims 11 or 24, wherein said metal bump is silver.

26.    The Schottky diode defined in claim 1, wherein said first region (44) is formed of two sub-regions:

(1)  a first sub-region of a substantially uniform first conductivity disposed adjacent said second surface; and

(2)  a second sub-region of a substantially uniform second conductivity disposed adjacent to and between said first sub-region and said first surface, said second conductivity being greater than said first conductivity.

27.    The Schottky diode defined in claim 26, wherein said first conductivity is $N^+$ conductivity and said second conductivity is N conductivity.

28.    The Schottky diode defined in claim 27, wherein said second sub-region comprises an epitaxial layer on said first sub-region.

29.    The Schottky diode defined in claim 28, wherein said epitaxial layer has a thickness in the range of 2.5 - 6.0 microns.

1/9

0093866

PRIOR ART

FIG.1

PRIOR ART

FIG.2

PRIOR ART

FIG.3

FIG.4

FIG.5

FIG.6

FIG.7

FIG.8A

FIG.8B

4/9

0093866

FIG.8C

FIG.8D

FIG.8E

FIG.8F

FIG.8G

FIG.8H

FIG.8I

FIG.8J

FIG 9

FIG.IOA

FIG.IOB

FIG.IOC

FIG.10D

FIG.10E

FIG.10F

138

138

144

142

140

132

122

120

FIG.10G

150

FIG.10H